(19) Europäisches Patentamt
European Patent Office
Office européen des brevets

(11) **EP 2 251 985 A1**

(12) **EUROPEAN PATENT APPLICATION**
published in accordance with Art. 153(4) EPC

(43) Date of publication:
**17.11.2010 Bulletin 2010/46**

(51) Int Cl.:
*H04B 1/16* (2006.01)    *H03G 3/20* (2006.01)
*H03G 3/30* (2006.01)    *H04B 1/18* (2006.01)

(21) Application number: **09714175.8**

(22) Date of filing: **24.02.2009**

(86) International application number:
**PCT/JP2009/000789**

(87) International publication number:
**WO 2009/107359 (03.09.2009 Gazette 2009/36)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **29.02.2008 JP 2008049080**

(71) Applicant: **Panasonic Corporation**
**Kadoma-shi**
**Osaka 571-8501 (JP)**

(72) Inventors:
• **OKADA, Eiji**
**c/o Panasonic Corporation, IPROC**
**Osaka-shi, Osaka 540-6207 (JP)**

• **NISHIMURA, Daisuke**
**c/o Panasonic Corporation, IPROC**
**Osaka-shi, Osaka 540-6207 (JP)**
• **OZEKI, Hiroaki**
**c/o Panasonic Corporation, IPROC**
**Osaka-shi, Osaka 540-6207 (JP)**
• **SAITO, Noriaki**
**c/o Panasonic Corporation, IPROC**
**Osaka-shi, Osaka 540-6207 (JP)**
• **FUKUSHIMA, Susumi**
**c/o Panasonic Corporation, IPROC**
**Osaka-shi, Osaka 540-6207 (JP)**

(74) Representative: **Kügele, Bernhard et al**
**Novagraaf International SA**
**Avenue du Pailly 25**
**1220 Les Avanchets-Genève (CH)**

(54) **AMPLIFIER CIRCUIT AND RECEIVING DEVICE USING THE SAME**

(57) An amplifier circuit includes a variable gain amplifier that amplifies and outputs a signal from an output port, a controller operable to change an gain of the variable gain amplifier, a mixer that mixes the signal output from the output port of the variable gain amplifier with a local oscillating signal to heterodyne the signal and outputs the heterodyned signal, a filter that outputs a signal component having a predetermined frequency out of the signal output from the mixer, and a detector that detects a power level based on power of the signal output from the filter. The controller is operable to change the gain according to the first power level such that a quality level representing quality of the signal output from the filter becomes a target quality level immediately after the gain is changed. The amplifier circuit can have small power consumption.

FIG. 1

EP 2 251 985 A1

**Description**

TECHNICAL FIELD

The present invention relates to an amplifier circuit and to a receiver including the amplifier circuit, used for a communication device, such as a mobile phone.

BACKGROUND OF THE INVENTION

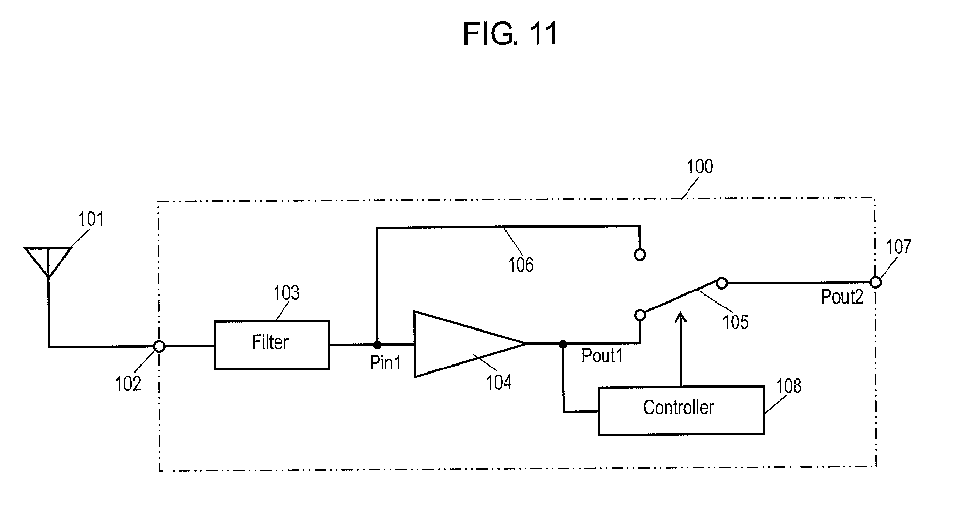

Fig. 11 is a block diagram of conventional amplifier circuit 100 used for a communication device, such as a mobile phone, described in patent literature 1. Amplifier circuit 100 includes input terminal 102 to which a signal from antenna 101 is input, filter 103 connected to input terminal 102 to remove a noise in the signal from the antenna, amplifier 104 connected to the output of filter 103, switch 105 connected to the output of amplifier 104, bypass line 106 that connects the output of filter 103 to switch 105, output terminal 107 connected to the output of switch 105, and controller 108 that controls switch 105. Controller 108 detects a power level of a signal output from amplifier 104 to control switch 105 according to the power level.

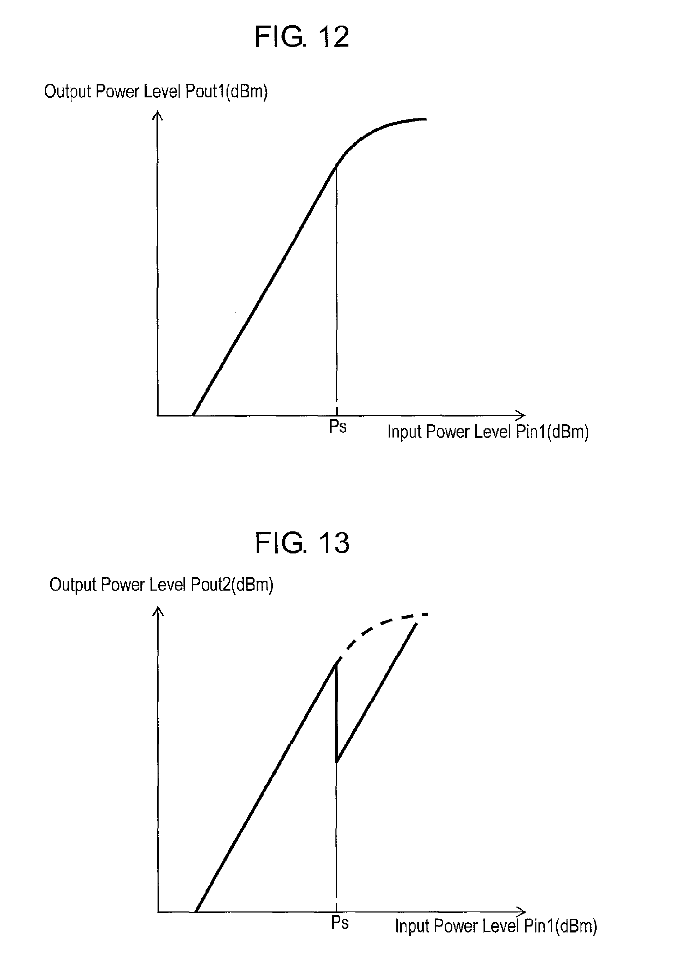

Fig. 12 shows relationship between power level Pin1 of a signal output from filter 103 and input to amplifier 104, and power level Pout1 output from amplifier 104. In Fig. 12, the horizontal axis represents the power level of the signal input to amplifier 104, and the vertical axis represents the power level of the signal output from amplifier 104. As shown in Fig. 12, when the power level input to amplifier 104 is not smaller than threshold level Ps, the output is linear with respect to the input. When power level Pin1 input to amplifier 104 is larger than threshold level Ps, power level Pout1 output is nonlinear with respect to input, hence distorting the output signal. The distorted signal is not demodulated accurately, deteriorating receiving characteristics. In conventional amplifier circuit 100, when power level Pin1 of a signal input to amplifier 104 exceeds threshold level Ps, controller 108 controls switch 105 to connect bypass line 106 to output terminal 107 and disconnects amplifier 104 from output terminal 107. This operation prevents the output signal distorted in amplifier 104 from being sent to output terminal 107. Fig. 13 shows relationship between power level Pin1 of a signal input to amplifier 104 of amplifier circuit 100 and power level Pout2 of a signal output from output terminal 107. In Fig. 13, the horizontal axis represents power level Pin1 of the signal input to amplifier 104, and the vertical axis represents power level Pout2 of the signal output from amplifier 104. As shown in Fig. 13, even when power level Pin1 input to amplifier 104 exceeds threshold level Ps, power level Pout2 is linear with respect to power level Pin1. Even when power level Pin1 input to amplifier 104 exceeds threshold level Ps, the signal output from output terminal 107 does not distort, reducing deterioration of receiving characteristics.

In conventional amplifier circuit 100, since controller 108 controls switch 105 to avoid distortion in amplifier 104, threshold Ps of a power level is determined to be a relatively large value. In this case, the probability of the case that power level Pin1 of a signal input to amplifier 104 is smaller than threshold Ps is higher than the case that power level Pin1 is larger than threshold level Ps. Hence, amplifier 104 stops its operation, and a signal passes through bypass line 106 for a short period of time, hence preventing power consumption from being reduced.

Patent Literature 1: JP2003-133983A

SUMMARY OF THE INVENTION

An amplifier circuit includes a variable gain amplifier that amplifies and outputs a signal from an output port, a controller operable to change an gain of the variable gain amplifier, a mixer that mixes the signal output from the output port of the variable gain amplifier with a local oscillating signal to heterodyne the signal and outputs the heterodyned signal, a filter that outputs a signal component having a predetermined frequency out of the signal output from the mixer, and a detector that detects a power level based on power of the signal output from the filter. The controller is operable to change the gain according to the first power level such that a quality level representing quality of the signal output from the filter becomes a target quality level immediately after the gain is changed.
The amplifier circuit can have small power consumption.

BRIEF DESCRIPTION OF DRAWINGS

Fig. 1 is a block diagram of a receiver including an amplifier circuit according to Exemplary Embodiment 1 of the present invention.
Fig. 2 shows a signal input to the receiver according to Embodiment 1.
Fig. 3A shows a quality level of a signal of the receiver according to Embodiment 1.
Fig. 3B shows a quality level of a signal of the receiver according to Embodiment 1.
Fig. 3C shows a quality level of a signal in the receiver according to Embodiment 1.
Fig. 4 shows a quality level of a signal of the receiver according to Embodiment 1.
Fig. 5 shows a quality level of a signal of the receiver according to Embodiment 1.
Fig. 6A shows a quality level of a signal of the receiver according to Embodiment 1.
Fig. 6B shows a database stored in a controller of the amplifier circuit according to Embodiment 1.
Fig. 7 is a circuit diagram of another variable gain amplifier of an amplifier circuit according to Exemplary Embodiment 2 of the invention.

Fig. 8 shows characteristics of a field-effect transistor (FET) of the variable gain amplifier.
Fig. 9 shows characteristics of the FET.
Fig. 10 shows a quality level of a signal of the amplifier circuit according to Embodiment 2.
Fig. 11 is a block diagram of a conventional amplifier circuit.
Fig. 12 shows characteristics of an amplifier of the conventional amplifier circuit.
Fig. 13 shows characteristics of the conventional amplifier circuit.

REFERENCE NUMERALS

2      Input Port
3      Output Port
4      Amplifier
4A     Variable Gain Amplifier
4B     Variable Gain Amplifier
5      Controller
6      RF Variable Gain Amplifier
7      Mixer
8      Filter
9      IF Variable Gain Amplifier
11     Detector (First Detector)
12     Detector (Second Detector)
13     Switch
15     Signal Processor
16     Display
P1     Power Level (First Power Level)
P2     Power Level (Second Power Level)

DETAILED DESCRIPTION OF PREFERRED EMBODIMENTS EXEMPLARY EMBODIMENT 1.

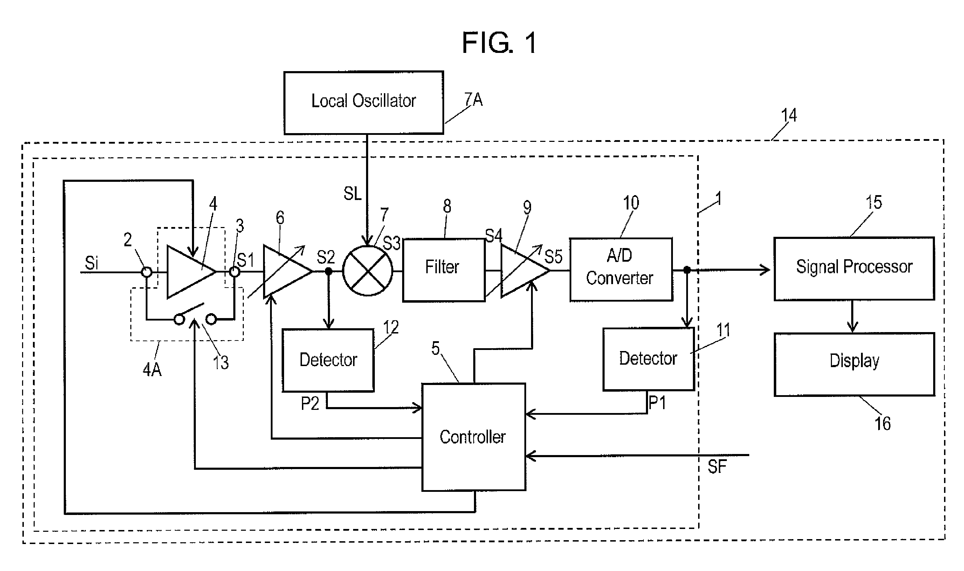

Fig. 1 is a block diagram of receiver 14 according to Exemplary Embodiment 1 of the present invention. Receiver 14 includes local oscillator 7A that generates local oscillating signal SL, amplifier circuit 1, signal processor 15, and display 16. Amplifier circuit 1 includes amplifier 4 that amplifies signal Si input from input port 2 and outputs the amplified signal from output port 3, radio-frequency (RF) variable gain amplifier 6 that amplifies signal S1 output from output port 3 of amplifier 4, mixer 7 that mixes local oscillating signal SL with signal S2 output from RF variable gain amplifier 6 to heterodyne signal S2, filter 8 that removes noise in signal S3 output from mixer 7, intermediate-frequency (IF) variable gain amplifier 9 that amplifies signal S4 output from filter 8, and A/D converter 10 that converts signal S5 output from IF variable gain amplifier 9 to digital data. Signal processor 15 processes the digital data output from A/D converter 10. Display 16 displays an image based on the data processed by signal processor 15. Detector 11 detects, based on data output from A/D converter 10, power level P1 corresponding to the power of signal S5 output from IF variable gain amplifier 9. Detector 12 detects power level P2 corresponding to the power of signal S2 output from RF variable gain amplifier 6. Switch 13 connected between input port 2 and output port 3 of amplifier 4 connects and disconnects between input port 2 and output port 3. Controller 5 controls power supplied to amplifier 4, switch 13, and the gains of RF variable gain amplifier 6 and IF variable gain amplifier 9 based on power levels P1 and P2 of signals S2 and S5 detected by detectors 11 and 12. Amplifier 4 and switch 13 constitute variable gain amplifier 4A having input port 2 and output port 3. Specifically, controller 5 disconnects switch 13 and supplies power to amplifier 4 to allow variable gain amplifier 4A to amplify signal Si input to input port 2 by the gain of amplifier 4, and outputs the amplified signal from output port 3. Controller 5 connects switch 13 and stops power supply to amplifier 4 to allow variable gain amplifier 4A to output signal Si to input port 2 directly, i.e., by the gain of 0 dB.

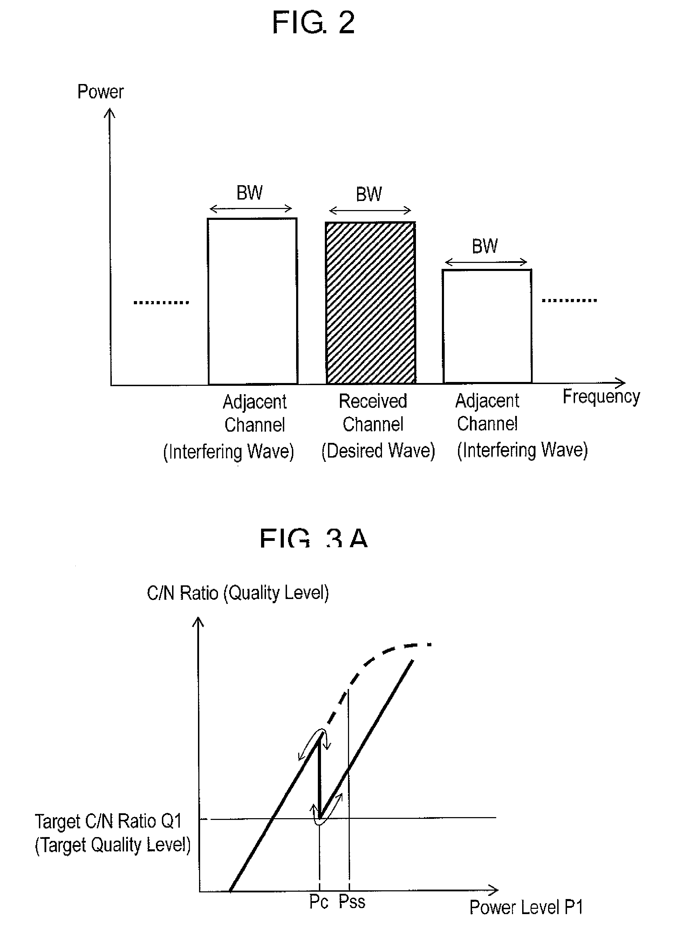

Fig. 2 shows signal Si input to input port 2. According to this embodiment, signal Si is a TV broadcasting signal. In Fig. 2, the horizontal axis represents the frequency of signal Si, and the vertical axis represents the power level of signal Si at the frequency. Plural channels for TV broadcasting have frequency bands BW of about 6 MHz adjacent to each other. While receiver 14 receives a signal of channel 18 as a desired wave, signals of channels 17 and 19 (not channel 18) are qualified as interfering waves. Signal Si input to input port 2 thus includes a desired wave and interfering waves. Filter 8 outputs only the desired wave which is a signal of a predetermined frequency component out of signals output from mixer 7 and does not pass signals having frequency components other than the predetermined frequency. Each of signals S1 to S3 before being input to filter 8 includes a desired wave and an interfering wave. Signal S2 detected by detector 12 includes both of a desired wave and an interfering wave. Power level P2 corresponds to the sum of respective powers of the desired wave and the interfering wave. Filter 8 removes most of the interfering wave from signal S2, and allows signal S4 output from filter 8 to mainly contain the desired wave, not the interfering wave. Hence, power level P1 detected by detector 11 represents mainly the power level of the desired wave.
Controller 5 controls the gain of IF variable gain amplifier 9 based on power level P1 of signal S5 to prevent the signal from distorting in an active element, such as a semiconductor element, at a stage subsequent to IF variable gain amplifier 9. Controller 5 adjusts the gain of RF variable gain amplifier 6 based on power level P2 of signal S2 to prevent an active element at a stage subsequent to RF variable gain amplifier 6 from distorting.
Detectors 11 and 12 detect an average value or a peak value of instantaneous power of signals S5 and S2 as power levels P1 and P2, respectively. Power levels P1 and P2, upon being the average values of instantaneous powers, are stable. The ratio of the average value to the peak value of the instantaneous power varies depending on a method of modulating a signal. Power levels P1 and P2, upon being the peak values of the instantaneous power largely utilize the performance of an active element at the stage subsequent to RF variable gain amplifier 6 or IF variable gain amplifier 9.

If detectors 11 and 12 can detect a peak value of power of a signal, detector 12 may count the number of cases where the peak value of power of the interfering wave exceeds a predetermined number to detect the power level based on the counted number. Such averaging stabilizes power levels P1 and P2 even when the peak value of the instantaneous power frequently changes at short time intervals.

Controller 5 controls switch 13 based on power level P1 to connect and disconnect switch 13, and controls power supplied to amplifier 4.

First, an operation of amplifier circuit 1 in the case that the power of the interfering wave is extremely smaller than that of the desired wave, namely the interfering wave is negligible with respect to the desired wave, or an interfering wave does not exist substantially will be described below.

Fig. 3A shows a quality level representing the quality of a signal of amplifier circuit 1. In Fig. 3A, the horizontal axis represents power level P1, and the vertical axis represents a carrier/noise (C/N) ratio as the quality level. Power level P1 may be calculated from transmission characteristics (e.g. the gain of IF variable gain amplifier 9, a loss of filter 8) and the power level, or from an average value of the power level.

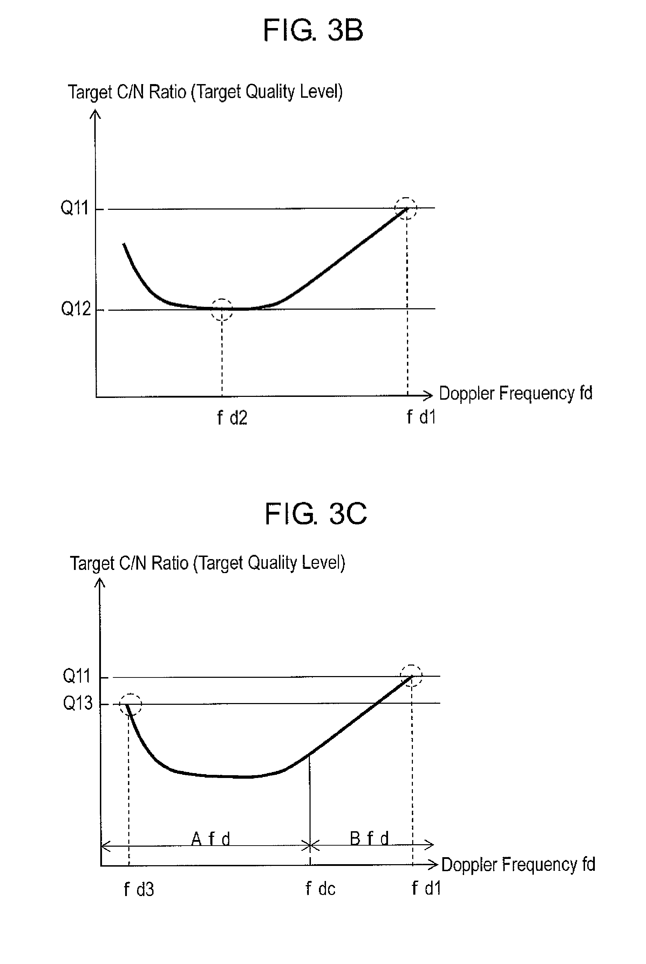

In Fig. 3A, power level Pss on the horizontal axis corresponds to threshold Ps shown in Figs. 12 and 13, and means a value at which amplifier 4 starts distorting. In Fig. 3A, the graph slopes gently at power level P1 larger than power level Pss. This means the increase rate of the C/N ratio is smaller at a larger power level P1. At power level P1 larger than power level Pss, signal S1 output from amplifier 4 distorts and prevents data represented by its amplitude from being demodulated, resulting in a small increase rate of the C/N ratio. In amplifier circuit 1, controller 5 turn on switch 13 and stops power supply to amplifier 4 when power level P1 is larger than switching threshold Pc. When power level P1 is smaller than switching threshold Pc, controller 5 turn off switch 13 and supplies power to amplifier 4. When switch 13 is turned on and the power supply to amplifier 4 is stopped, power level P1 causing a C/N ratio (i.e. quality level) to become a target C/N ratio (i.e. target quality level) is set to switching threshold Pc. The target quality level is a minimum quality level required to allow receiver 14 to receive a signal of a desired wave. The target quality level corresponds to a target C/N ratio according to Embodiment 1 in which the quality level is the C/N ratio. A minimum required quality level for receiving a signal of a desired wave is uniquely defined by the specifications of a receiving system, and accurately, is calculated in consideration of the deterioration amount of reception characteristics due to changes of incoming waves in a fading environment. For instance, to evaluate the fading performance of a receiving system for digital terrestrial broadcasting, GSM Typical Urban 6-path model is used as a multi-path Rayleigh fading model. Fig. 3B shows the target C/N ratio when Doppler frequency fd is changed in this model while receiver 14 moves. As shown in Fig. 3B, the target C/N ratio decreases as the moving speed of receiver 14 changes from a low speed to an intermediate speed, and increases as the moving speed of receiver 14 changes from the intermediate speed to a high speed. The target C/N ratio is maximum value Q11 at upper limit fd1 of Doppler frequency fd that is practically taken. The target C/N ratio becomes minimum value Q12 at Doppler frequency fd2. Controller 5 determines the target C/N ratio (i.e. target quality level) as maximum value Q11 and determines switching threshold Pc based on maximum value Q11.

Controller 5 may change switching threshold Pc according to Doppler frequency fd. To reduce power consumption, the target C/N ratio is preferably smaller to decrease switching threshold Pc. Controller 5 detects Doppler frequency fd and calculates a target C/N ratio (i.e. target quality level) on the basis of detected Doppler frequency fd to change switching threshold Pc. This operation reduces power consumption of amplifier circuit 1 while receiver 14 moves at a low speed. Specifically, controller 5 may change the target C/N ratio between maximum value Q11 and minimum value Q12 according to Doppler frequency fd to change switching threshold Pc. Controller 5 may change the target C/N ratio (i.e. target quality level) according to Doppler frequency fd to change switching threshold Pc as follows. Fig. 3C shows the target C/N ratio when Doppler frequency fd is changed. In region Afd where Doppler frequency fd is lower than switching frequency fdc, controller 5 sets largest value Q13 in region Afd as the target C/N ratio to determine switching threshold Pc. In region Bfd where Doppler frequency fd is higher than switching frequency fdc, controller 5 sets largest value Q11 in region Bfd as the target C/N ratio to determine switching threshold Pc. In Fig. 3C, Doppler frequency fd is divided into two regions Afd and Bfd; however, Doppler frequency fd may be divided into three or more regions and the target C/N ratio (i.e. target quality level) may be set to a maximum value in each region to determine switching threshold Pc for each region.

Controller 5 may change the target C/N ratio and switching threshold Pc according to Doppler velocity Vd (i.e. the moving speed of receiver 14) instead of Doppler frequency fd. Doppler velocity Vd is expressed by the following expression with frequency fi of signal Si received and the speed Vc of light.

$$Vd = fd \times Vc/fi$$

Doppler velocity Vd changes depending on frequency fi of signal Si even if Doppler frequency fd is fixed. Specifically, the above expression above shows that Doppler velocity Vd increases as frequency fi of signal Si decreases for fixed Doppler frequency fd. In order to determine the target quality level and switching threshold Pc according to Doppler velocity Vd, controller 5 may change switching threshold Pc according to frequency fi since the target quality level changes according to frequency fi of signal Si. Doppler frequency fd is lowered, and the target C/N ratio decreases as frequency fi is lowered, thereby decreasing switching threshold Pc and reducing power consumption of amplifier circuit 1.

Doppler frequency fd or Doppler velocity Vd can be detected by estimating a transmission path using a received signal, by estimating the moving speed with reference to a radio tower according to the amount of time fluctuation in the amplitude or phase of multiple subcarrier signals received, or by estimating the moving speed with reference to the radio tower using a GPS or a velocity sensor.

Controller 5 of amplifier circuit 1 may determine the target C/N ratio according to the number of delayed waves to determine switching threshold Pc. Specifically, controller 5 counts the number of delayed waves having amplitude larger than a predetermined amplitude, changes the characteristics shown in Figs. 3A to 3C, and determines the target C/N ratio. Switching threshold Pc during moving is changed according to the number of multipath waves having power higher than a predetermined value in consideration of impulse response or delay profile while not moving. This further reduces power consumption of amplifier circuit 1. In an environment where the frequency spectrum of time fluctuation due to Doppler broadening mildly influences the characteristics of the frequency transfer function, that is, while not moving, the impulse response or the delay profile is calculated. Next, controller 5 corrects switching threshold Pc according to the number of multipath waves having power higher than a predetermined value for impulse response or according to broadening of delay profile, in this environment (not moving). This operation prevents controller 5 from changing the gain of variable gain amplifier 4A excessively when amplifier circuit 1 moves, hence reducing power consumption of amplifier circuit 1. Impulse response and delay profile while not moving are calculated as follows. Fourier transform of a signal during its demodulation in orthogonal frequency division multiplexing (OFDM), frequency transfer function T(f) (i.e. characteristics of amplitude to frequency) is calculated. Further, an inverse Fourier transform of frequency transfer function T(f) provides impulse response $h(\tau)$. Delay profile $p(\tau)$ is a time-average value of the product of impulse response $h(\tau)$ and its conjugate complex number $h^*(\tau)$.

Amplifier circuit 1 prevents amplifier 4 from distorting. In conventional amplifier circuit 100 shown in Fig. 11, power supply to amplifier 104 is stopped only when the power level is larger than threshold Ps at which amplifier 104 starts distorting. In amplifier circuit 1 according to Embodiment 1, controller 5 stops power supply to amplifier 4 when power level P1 is larger than switching threshold Pc that is smaller than power level Pss at which amplifier 4 starts distorting. Hence, amplifier circuit 1 can stop power supply to amplifier 4 more frequently than conventional amplifier circuit 100 shown in Fig. 11, thereby further reducing power consumption.

Controller 5 may change switching threshold Pc according to frequency fi of signal Si, namely, according to the frequency of local oscillating signal SL supplied to mixer 7. This operation allows controller 5 to control variable gain amplifier 4A with appropriate switching threshold Pc even if amplifier 4 has frequency characteristics. In this case, controller 5 previously stores plural values of frequency fi of signal Si and plural values of switching threshold Pc corresponding to the values of frequency fi. Controller 5 determines switching threshold Pc, corresponding to frequency fi received by receiver 14, out of plural multiple values of switching threshold Pc stored. Controller 5 compares switching threshold Pc determined with power level P1 to turns on and off switch 13 and controls power supplied to amplifier 4 to control variable gain amplifier 4A.

Controller 5 changes the gain of variable gain amplifier 4A, that is, turns on or off switch 13 simultaneously to the changing of respective gains of RF variable gain amplifier 6 and IF variable gain amplifier 9. This operation reduces fluctuation of the level of signals input to signal processor 15, thereby preventing deterioration of signal quality.

In digital terrestrial broadcasting, a modulated wave includes a signal period for a symbol and a guard interval during which a valid signal is not contained to reduce an influence of multi-path and fading. When receiver 14 receives a signal containing a guard interval, controller 5 changes the gains of variable gain amplifiers 4A, 6, and 9 during the guard interval, and does not change the gains during the signal period, thereby reducing influence of fluctuation of the level of the signal due to the change of the gains.

When power level P1 fluctuates around switching threshold Pc, switch 13 is switched frequently. When switch 13 is switched, signal S1 output from amplifier 4 changes largely, and causes noise. Hence, switch 13 switched frequently can deteriorate the quality of the signal.

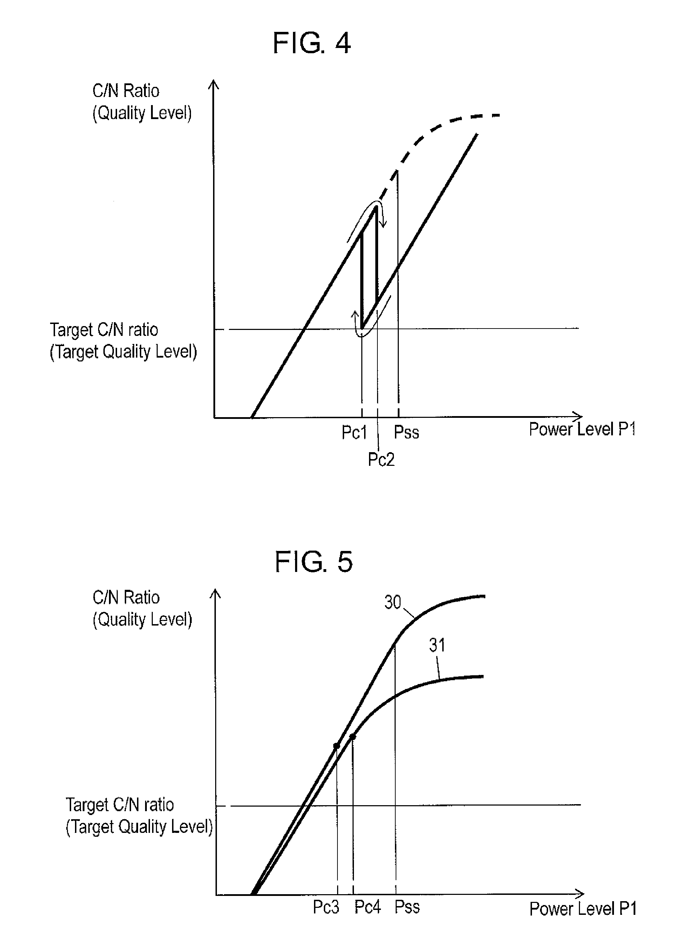

In order to prevent the quality deterioration, controller 5 may have hysteresis characteristics. Fig. 4 shows the C/N ratio (i.e. quality level) in the case that controller 5 has the hysteresis characteristics. In Fig. 4, the horizontal axis represents power level P1, and the vertical axis represents the C/N ratio (i.e. quality level). While controller 5 turns off switch 13 and supplies power to amplifier 4, controller 13 turns on switch 13 and stops supplying power to amplifier 4 when power level P1 exceeds switching threshold Pc2. On the other hand, while controller 5 turns on switch 13 and does not supply power to amplifier 4, controller 5 turns off switch 13 and supplies power to amplifier 4 when power level P1 becomes smaller than switching threshold Pc1. Two switching thresholds Pc1 and Pc2 prevent switch 13 from being frequently switched in a short time, and prevents deterioration of signal quality.

When fading causes power level P1 to fluctuate beyond the range between switching thresholds Pc1 and Pc2 in a short time, controller 5 changes switch 13 frequently at short time intervals even if having the characteristics shown in Fig. 4, which causes the signal quality to deteriorate. In order to avoid this problem, controller 5 may average power level P1 for a predetermined period and compare the averaged value with switching thresholds Pc1 and Pc2 to change switch 13. Controller 5 monitors power level P1 at predetermined time intervals and counts the number of times when power level P1 exceeds switching threshold Pc2 and the number of times when value P1 becomes smaller than switching threshold Pc1 for a predetermined period. When the number of times when power level P1 exceeds switching threshold Pc2 exceeds a predetermined number, controller 5 turns on switch 13 and stops power supply to amplifier 4. When the number of times when power level P1 becomes smaller than switching threshold Pc1 exceeds a predetermined number, controller 5 turns off switch 13 and supplies power to amplifier 4. Timing for changing switch 13 can be freely determined by determining a clock speed defining the time intervals. Controller 5 monitors power level P1 once every one symbol of a signal and counts the number of times when power level P1 exceeds switching threshold Pc2 and the number of times when value P1 becomes smaller than switching threshold Pc1 for the predetermined period. Similarly, when the number of times when power level P1 exceeds switching threshold Pc2 exceeds the predetermined number, controller 5 turns on switch 13 and stops power supply to amplifier 4. When the number of times when power level P1 is smaller than switching threshold Pc1 exceeds the predetermined number, controller 5 turns off switch 13 and supplies power to amplifier 4. This operation does not require a clock pulse separately generated to define the time intervals for monitoring power level P1, and reduces the size and power consumption of amplifier circuit 1.

Controller 5 thus averages power level P1 to prevent switch 13 from frequently being changed even if power level P1 fluctuates beyond the range between switching thresholds Pc1 and Pc2, which prevents deterioration of the quality of a signal received.

The averaging stabilizes power level P1, thereby increasing the accuracy of switching thresholds Pc1 and Pc2.

Changing switch 13 at a certain time interval T may cause a noise having frequency 1/T. Controller 5 may change switch 13 not periodically, not at a constant time interval, thereby reducing the noise.

Next, an operation of amplifier circuit 1 in the case that signal Si contains an interfering wave with nonnegligibly high power relative to a desired wave, as shown in Fig. 2, will be described below. In this case, the interfering wave generates harmonics in the frequency band of the desired wave in active elements of amplifier 4, RF variable gain amplifier 6, and mixer 7. The harmonics largely deteriorate the quality of a signal in the frequency band of the desired wave as noise. Hence, when switch 13 is turned on and power supplied to amplifier 4 is stopped, the target quality level may not be determined. If the power of the interfering wave is higher than that of the desired wave, RF variable gain amplifier 6 can distort due to the power of the interfering wave, and thus controller 5 adjusts the gain of RF variable gain amplifier 6 based on power level P2 of signal S2. Since signal S2 contains both desired and interfering waves, controller 5 controls the gains of RF variable gain amplifier 6 and IF variable gain amplifier 9 according to the power of the desired and interfering waves. As the result, the noise figure (NF) characteristics of amplifier circuit 1 change according to the power of the desired and interfering waves, which changes the profile of the C/N ratio according to power level P1 shown in Figs. 3A and 4. If the ratio of the power of the desired wave to that of the interfering wave is determined, however, the C/N ratio corresponding to power level P1 shown in Fig. 3A and 4 is uniquely determined. Fig. 5 shows relationship between power level P1 and the C/N ratio representing quality of a signal in the case that the interfering wave is nonnegligible. In Fig. 5, the horizontal axis represents power level P1, and the vertical axis represents the C/N ratio. Profiles 30 and 31 indicate C/N ratios when the ratios of the power of an interfering wave to that of a desired wave are values R1 and R2, respectively. Value R1 is smaller than value R2. The power of the interfering wave on profile 31 is larger than that on profile 30. Hence, amplifier 4 distorts unless the gain of RF variable gain amplifier 6 starts decreasing earlier than profile 30 for a large power level P1. Harmonics noise resulting from the interfering wave is generated even in the band of the desired wave, and thus the C/N ratio of profile 31 is smaller than that of profile 30. Controller 5 changes switch 13 and power supply to amplifier 4 at switching threshold Pc3 when the ratio of the power of the interfering wave to that of the desired wave is value R1, and changes switch 13 and power supply to amplifier 4 at switching threshold Pc4 when the ratio is value R2. In other words, controller 5 changes the gain of variable gain amplifier 4A at switching threshold Pc3 when the ratio of the power of the interfering wave to that of the desired wave is value R1, and changes the gain of variable gain amplifier 4A at switching threshold Pc4 when the ratio is value R2. Switching threshold Pc3 is smaller than switching threshold Pc4.

Here, the ratio of the power of the interfering wave to that of the desired wave can be derived in consideration of the power of the desired wave band out of power level P2 based on the passing characteristics between detector 11 and detector 12, and of power level P1, for instance. The ratio is the ratio of power level P2 to power level P1 according to Embodiment 1; however, it may be the ratio of the power of the desired wave to that of the interfering wave, in consideration of the desired wave component of power level P2 based on power level P1, calculated based on power levels P1 and P2. The ratio of power level P2 to power level P1 represents the ratio of the power of the interfering wave to that of the desired wave. Controller 5 may calculate a value correlated to the ratio of the power of the interfering wave to that of the desired wave including the gain of RF variable gain amplifier 6, to change the switching threshold according to the value. In Fig. 1, power level P2 detected by detector 12 is the power of signal S2 output from RF variable gain amplifier 6; however, it may be the value of power of signal S3 output from mixer 7. Signal S3 contains both the desired and interfering waves, and thus, detector 12 can detect the power level of the interfering wave by inputting signal S3 to detector 12 through a filter that removes the desired wave and passes through only the interfering wave. Controller 5 can calculate the ratio of the power of the interfering wave to that of the desired wave.

Ratio RS of power level P1 to P2 and switching thresholds Pc3, Pc4 are previously determined for each frequency band of a signal. Controller 5 previously stores these values determined. Controller 5 selects one switching threshold Pc out of switching thresholds Pc3 and Pc4 according to a frequency band in which receiver 14 receives and ratio RS of power level P1 to power level P2. After that, controller 5 compares the value of switching threshold Pc with power level P1 to turn on and off switch 13 and controls power supplied to amplifier 4 to control variable gain amplifier 4A.

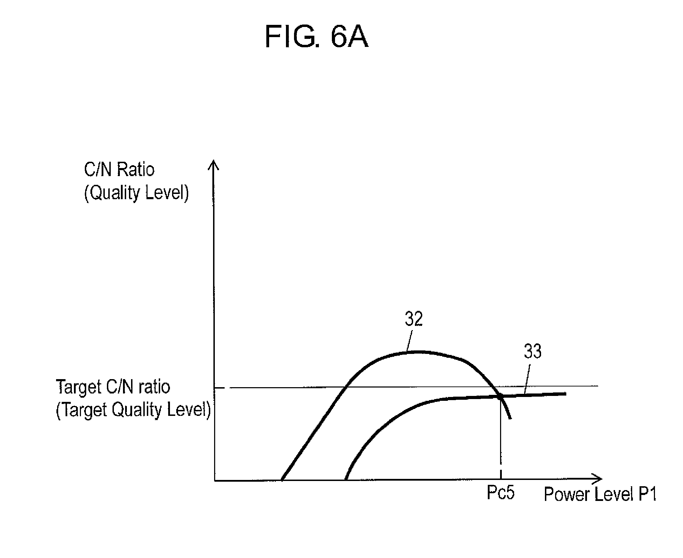

Fig. 6A shows relationship between power level P1 and the C/N ratio in the case that the power of the interfering wave is extremely larger than that of the desired wave. Profile 32 shows the C/N ratio in the case that controller 5 turns off switch 13 and supplies power to amplifier 4. Profile 33 shows the C/N ratio in the case that controller 5 turns off switch 13 and stops supplying power to amplifier 4. Since the power of the interfering wave is extremely large, the C/N ratio of profile 32 shown in Fig. 6A for large power level P1 is smaller than that of profile 30 shown in Fig. 5, exhibiting larger deterioration. Hence, on profile 33 shown in Fig. 6A, the C/N ratio of the signal of amplifier circuit 1 is smaller than the target C/N ratio regardless of power level P1 in the case that switch 13 is turned on and power supply to amplifier 4 is stopped. In this case, as shown in Fig. 6A, controller 5 determines power level P1 at a point where profiles 32 and 33 crosses as switching threshold Pc5. Then, controller 5 turns on switch 13 and stops power supply to amplifier 4 when power level P1 is larger than switching threshold Pc5. When power level P1 is smaller than switching threshold Pc5, controller 5 turns off switch 13 and supplies power to amplifier 4. This operation reduces deterioration of the C/N ratio.

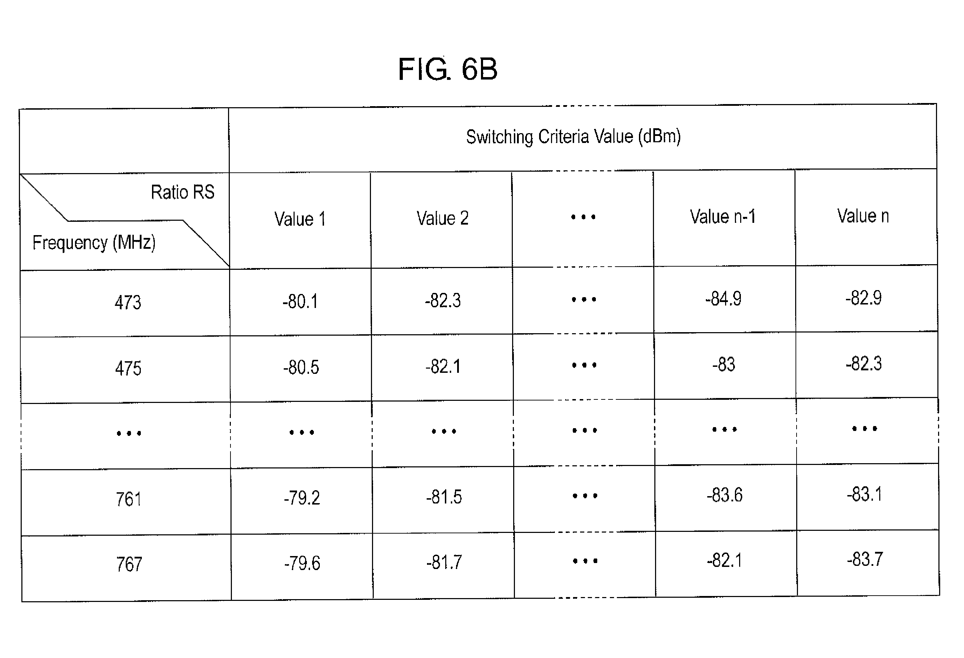

Fig. 6B shows a database stored by controller 5 which contains frequency bands, ratios RS of power level P1 to power level P2, and switching thresholds corresponding to them. As shown in Fig. 6B, the switching thresholds are determined previously for each frequency band and each value of ratio RS. Controller 5 receives signal SF indicating a frequency to be received and selects a switching threshold according to the frequency and ratio RS to control the gain of variable gain amplifier 4A.

If ratio RS is below or above a predetermined value, the switching threshold may be fixed. For instance, when ratio RS is below a certain predetermined value, the switching threshold is to be fixed. If the predetermined value in this case is extremely large, it means that the power of the desired wave is extremely larger than that of the interfering wave when ratio RS is above the predetermined value. In such a state, controller 5 can determine the gains of RF variable gain amplifier 6 and IF variable gain amplifier 9 only according to power level P1 regardless of power level P2, and thus can determine relationship between power level P1 and the C/N ratio regardless of power level P2 as shown in Figs. 3A and 4. Thus, with an appropriate predetermined value determined, the switching threshold can be fixed when ratio RS becomes above or below this predetermined value. With the switching threshold made fixed, controller 5 does not need to select a switching threshold every time ratio RS changes, thereby reducing power consumption of amplifier circuit 1. Additionally to this, in a range of ratio RS with the switching threshold is fixed, the frequence at which detector 12 sends power level P2 to controller 5 may be smaller than that at which detector 11 sends power level P1 to controller 5,. When ratio RS becomes below or above a predetermined value and the switching threshold is fixed, the ratio of the change of the switching threshold to the change of ratio RS decreases. In this way, controller 5 only needs to determine whether ratio RS becomes above or below the predetermined value, and thus controller 5 can decrease the frequence at which detector 12 sends power level P2 to controller 5, thereby reducing power consumption. Here, the frequence at which detector 12 transmits power level P2 to controller 5 may be changed according to the difference between ratio RS at a certain moment and the predetermined value. For instance, in a range of ratio RS with the switching threshold fixed, controller 5 may reduce the frequence at which detector 12 sends power level P2 to controller 5 according to the increase of the difference between ratio RS at a certain moment and the predetermined value. The frequence at which power level P2 is sent to controller 5 may be changed proportionally to the change of the switching threshold to that of ratio RS even in the case that the range of ratio RS with the switching threshold fixed is not set. Specifically, a first predetermined value and a second predetermined value larger than the first predetermined value are provided. When the ratio of the change of the switching threshold to the change of ratio RS is smaller than the first predetermined value, detector 12 sends power level P2 to controller 5 at frequence FR1. When the ratio is larger than the first predetermined value and smaller than the second predetermined value, detector 12 sends power level P2 to controller 5 at frequence FR2. When the ratio is larger than the second predetermined value, detector 12 sends power level P2 to controller 5 at frequence FR3. Frequences FR1, FR2, and FR3 may satisfy the following relation.

$$FR1 < FR2 < FR3$$

The above relation effectively reduces the number of times when detector 12 sends power level P2 to controller 5, thereby reducing power consumption of amplifier circuit 1. Here, the first predetermined value may be identical to the second predetermined value. Alternatively, the ratio of the change of the switching threshold to the change of ratio RS may be compared to plural predetermined values so as to change the time interval at which power level P2 is transmitted to controller 5 inversely proportionally to the predetermined values, thereby providing the same effects

Alternatively, controller 5 may increase the time interval at which detector 11 sends power level P1 to controller 5 when the change of power level P1 is smaller than the first predetermined value, and may decrease the time interval when the change of power level P1 is larger than the first predetermined value. Controller 5 may also increase the time interval at which detector 12 sends power level P2 to controller 5 when the change of power level P2 is smaller than the first predetermined value, and may decrease the time interval when the change of power level P2 is larger than the first predetermined value. In other words, the time interval at which at least one of power levels P1 and P2 is transmitted to controller 5 is changed. If a value transmitted currently to controller 5 is changed from the value transmitted previously to controller 5 by a value smaller than the first predetermined value, the time interval increases. If the value transmitted currently to controller 5 is changed from the value transmitted previously to controller 5 by a value larger than the second predetermined value, the time interval decreases.

The frequence at which power level P2 is sent to controller 5 may be changed proportionally to the temporal fluctuation range of ratio RS even in the case that a range of ratio RS with the switching threshold fixed is not set. Specifically, when the change of ratio RS is smaller than the first predetermined value, the time interval at which detector 12 sends power level P2 to controller 5 may be increased. When the change of ratio RS is larger than the first predetermined value, the time interval at which detector 12 sends power level P2 to controller 5 may be decreased. In this case, the first predetermined value may be identical to the second predetermined value. The change of ratio RS may be compared to plural predetermined values so as to change the time interval at which detector 12 sends power level P2 to controller 5 inversely proportionally to the predetermined values, thereby providing the same effects.

Further, the time interval at which detector 11 sends power level P1 to controller 5 may be changed inversely proportionally to the change of power level P1. Specifically, when the change of power level P1 is smaller than the first predetermined value, the time interval at which detector 11 sends power level P1 to controller 5 may be increased. When the change of power level P1 is larger than the first predetermined value, the time interval at which detector 11 sends power level P1 to controller 5 may be decreased. In this case, the first predetermined value may be identical to the second predetermined value. The change of power level P1 may be compared to plural predetermined values so as to change the time interval at which detector 11 sends power level P1 to controller 5 changed inversely proportionally to the predetermined values, providing the same effects.

This operation effectively reduces the number of times when detectors 11 and 12 send power levels P1 and P2 to controller 5, respectively, thereby reducing power consumption.

While power level P1 is not sent to controller 5, controller 5 may stop power supply to detector 11 to stop an operation of detector 11. As described above, when the number of times when power level P1 is sent decreases, the frequence at which detector 11 detects power level P1 decreases, and thus detector 11 does not need to be always activated. Hence, while detector 11 is not detecting power level P1, controller 5 stops power supply to detector 11. This allows controller 5 to supply power to detector 11 only when detector 11 detects power level P1, providing amplifier circuit 1 with small power consumption.

Similarly, while power level P2 is not sent to controller 5, controller 5 may stop power supply to detector 12 to stop an operation of detector 12. As described above, when the number of times when power level P2 is sent decreases, the frequence at which detector 12 detects power level P2 decreases, and thus detector 12 does not need to be always activated. Hence, while detector 12 is not detecting power level P2, controller 5 stops power supply to detector 12. This allows controller 5 to supply power to detector only when detector 12 detects power level P2, providing amplifier circuit 1 with small power consumption.

Here, as shown in Fig. 5, even when the switching threshold is selected according to ratio RS of power level P2 to power level P1, controller 5 may change the gain of variable gain amplifier 4A with hysteresis characteristics having two switching thresholds Pc1 and Pc2 near the switching threshold selected, as shown in Fig. 4. This operation prevents variable gain amplifier 4A from changing.

In Fig. 1, amplifier circuit 1 does not necessarily include at least one of RF variable gain amplifier 6 and IF variable gain amplifier 9, providing the same effects. IF variable gain amplifier 9 may be positioned between mixer 7 and signal processor 15, providing the same effects.

Detector 11 may detect a power level of a signal at any position from filter 8 to signal processor 15 as power level P1. Similarly, detector 12 may detect a power level of a signal at any position from filter 8 to variable gain amplifier 4A as power level P2.

According to Embodiment 1, controller 5 determines the switching threshold as the quality level (representing quality of a signal) and a target quality level based on the C/N ratio and the target C/N ratio. Controller 5 may determine the switching threshold based on a bit error rate (BER) or packet error rate (PER).

EXEMPLARY EMBODIMENT 2

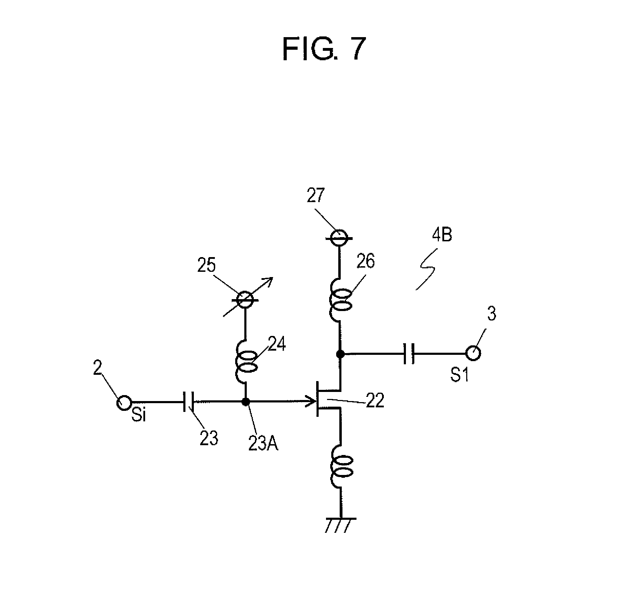

Fig. 7 is a circuit diagram of another variable gain amplifier 4B of amplifier circuit 1 instead of variable gain amplifier 4A according to Embodiment 1 shown in Fig. 1. Variable gain amplifier 4B amplifies signal Si input from input port 2 and outputs it as signal S1 from output port 3. Direct-current (DC) cut-off capacitor 23 is connected between the gate of field-effect transistor (FET) 22 and the input terminal. Variable voltage source 25 is connected via choke coil 35 to node 23A at which capacitor 23 is connected to the gate of FET 22. Constant voltage source 27 is connected to the drain of FET 22 via choke coil 26. Controller 5 shown in Fig. 1 controls the voltage value of variable voltage source 25 to change voltage $V_{GS}$ between the gate and source of FET 22, thereby controlling the gain of FET 22.

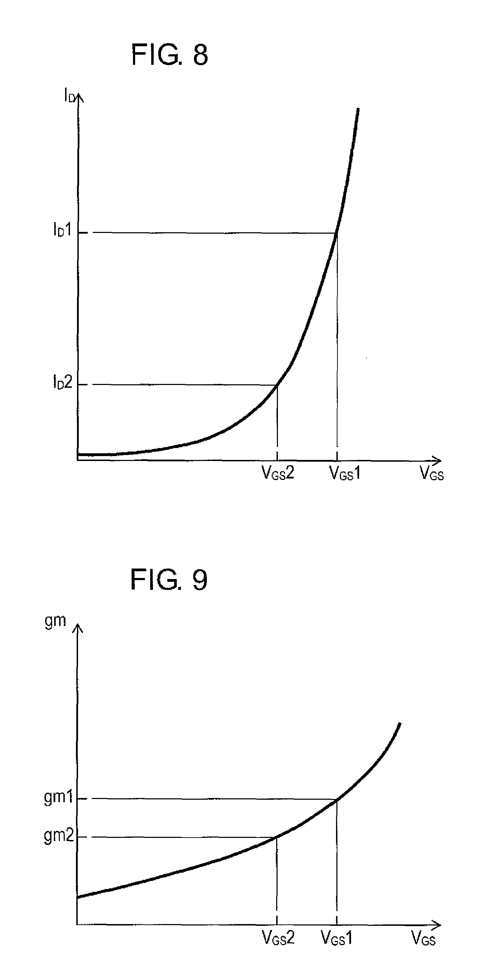

Fig. 8 shows voltage $V_{GS}$ between the gate and source of FET 22 and current $I_D$ flowing in the drain of FET 22. As shown in Fig. 8, as voltage $V_{GS}$ increases, current $I_D$ increases exponentially. That is, in order to reduce consumption current of amplifier 4B, current $I_D$ is decreased.

Fig. 9 is a graph of mutual conductance gm showing correlation between voltage $V_{GS}$ and current $I_D$. As voltage $V_{GS}$ decreases, mutual conductance gm decreases. Mutual conductance gm represents the gain of FET 22, and thus the gain of FET 22 decreases at lower voltage $V_{GS}$. Figs. 8 and 9 suggest that the consumption current of FET 22 is reduced with smaller gain of FET 22. The consumption current of amplifier circuit 1 can be reduced by reducing the gain of FET 22 as much as possible such that the target signal quality level is a minimum required quality level of a signal for receiver 14 to receive a signal in a desired band. Specifically, the quality level of receiver 14 becomes approximately the target signal quality level immediately after the gain of amplifier 4 is changed.

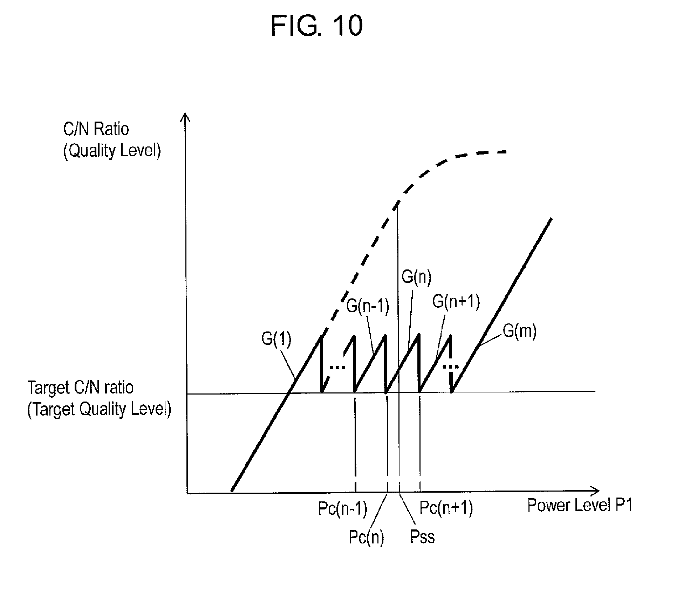

Fig. 10 shows a C/N ratio that is a quality level representing quality of a signal of amplifier circuit 1 including variable gain amplifier 4B instead of variable gain amplifier 4A. In Fig. 10, the horizontal axis represents power level P1, and the vertical axis represents the C/N ratio. Controller 5 (Fig. 1) can set gain G of variable gain amplifier 4B to gains G(1), ... , G(n-1) ,G(n) , G(n+1), ... , G(m) (where m and n are integers satisfying 2<n<m). Gain G satisfies G(k) > G(k+1) for any integer k (1≤k<m). Controller 5 stores respective power levels P1 causing the C/N ratio becomes the target C/N ratio where gains G of variable gain amplifier 4B are gains G(2), ... , G(n-1), G(n), G(n+1), ... , G(m) as switching thresholds Pc(2), ... , Pc(n-1), Pc(n), Pc(n+1), ... , Pc(m). When power level P1 changes from a value smaller than switching threshold Pc(n) to a value larger than Pc(n) while variable gain amplifier 4B amplifies signal Si at gain G(n-1), controller 5 (Fig. 1) decreases the voltage of variable voltage source 25 immediately after power level P1 exceeds switching threshold Pc(n) to decrease voltage $V_{GS}$ of FET 22, thereby decreasing gain G from gain G(n-1) to gain G(n). This operation decreases the C/N ratio as shown in Fig. 10 to cause the C/N ratio to be substantially identical to the target C/N ratio. Meanwhile, when power level P1 changes from a value larger than switching threshold Pc(n) to a value smaller than Pc(n) while variable gain amplifier 4B amplifies signal Si at gain G(n), controller 5 (Fig. 1) increases the voltage of variable voltage source 25 to increase voltage $V_{GS}$ of FET 22, thereby increasing gain G from gain G(n) to gain G(n-1) immediately after power level P1 becomes smaller than switching threshold Pc(n). Specifically, the C/N ratio increases as shown in Fig. 10, preventing the C/N ratio from being smaller than the target C/N ratio. This operation prevents the C/N ratio from being smaller than the target C/N ratio without increasing gain G of amplifier 4B unnecessarily. This operation prevents deterioration of signal quality while reducing consumption current of amplifier circuit 1.

Controller 5 may set gain G of variable gain amplifier 4B to a continuous value. In this case, controller 5 may adjust gain G so that the C/N ratio of a signal always becomes the target C/N ratio. Similarly to the amplifier circuit according to Embodiment 1, controller 5 may select a switching threshold based on both power levels P1 and P2, providing the same effects as Embodiment 1. Further, as shown in Fig. 4, controller 5 may have hysteresis characteristics, providing the same effect as Embodiment 1.

Amplifier circuit 1 according to Embodiments 1 and 2, with low power consumption, is useful particularly for a portable communication terminal usable for a long time.

INDUSTRIAL APPLICABILITY

Amplifier circuit 1 according to the present invention has low power consumption, and is useful particularly for a portable communication terminal usable for a long time.

**Claims**

1. An amplifier circuit comprising:

     a variable gain amplifier that amplifies a signal input from an input port and outputs the amplified signal from an output port;
     a controller operable to change an gain of the variable gain amplifier;
a mixer that mixes the signal output from the output port of the variable gain amplifier with a local oscillating signal to heterodyne the signal, and outputs the heterodyned signal;
a filter that outputs a signal component having a predetermined frequency out of the signal output from the mixer; and
a first detector that detects a first power level based on power of the signal output from the filter, wherein
the controller is operable to change the gain according to the first power level such that a quality level representing quality of the signal output from the filter becomes a target quality level immediately after the gain is changed.

2. The amplifier circuit according to claim 1, further comprising
a second detector that detects a second power level based on power of a signal between the output port of the variable gain amplifier and the filter, wherein
the controller is operable to change the gain according to the first power level and the second power level such that that the quality level representing quality of the signal output from the filter immediately after the gain is changed.

3. The amplifier circuit according to claim 2, wherein a frequency at which the first detector sends the first power level to the controller is higher than a frequence at which the second detector sends the second power level to the controller.

4. The amplifier circuit according to claim 2, wherein a time interval at which at least one of the first power level and the second power level is transmitted to the controller changes,
the time interval increases when a value currently transmitted to the controller is changed from a value previously transmitted to the controller by a value smaller than a first predetermined value, and
the time interval decreases when a value transmitted to the controller is changed from a value previously transmitted to the controller by a value larger than a second predetermined value.

5. The amplifier circuit according to claim 2, wherein the controller is operable to change the gain of the variable gain amplifier based on a value obtained by averaging the second power level for a predetermined period.

6. The amplifier circuit according to claim 1, wherein the variable gain amplifier includes
an amplifier that amplifies the signal input from the input port at a predetermined gain and outputs the amplified signal from the output port, and

a switch connected between the input port and the output port and connecting and disconnecting between the input port and the output port, and
the controller is operable to stop power supplied to the amplifier when the switch is turned on, and to supply power to the amplifier when the switch is turned off.

7. The amplifier circuit according to claim 1, wherein the controller is operable to change the gain immediately after the first power level exceeds a switching threshold, and
the switching threshold is different depending on a frequency of the local oscillating signal.

8. The amplifier circuit according to claim 1, wherein the controller is operable to
set the gain to gains $G(1), \ldots, G(n-1), G(n), \ldots, G(m)$, where n and m are integers satisfying $2 < n < m$,
store each power level P1 when a C/N ratio of a signal becomes a target C/N ratio when the gain is each of gains $G(2), \ldots, G(n-1), G(n), G(n+1), \ldots, G(m)$ as switching thresholds $Pc(2), \ldots, Pc(n-1), Pc(n), Pc(n+1), \ldots, Pc(m)$, respectively,
change the gain from gain $G(n-1)$ to $G(n)$ immediately after the power level P1 exceeds the switching threshold $Pc(n)$ when the first power level changes from a value smaller than the switching threshold $Pc(n)$ to a value larger than the switching threshold $Pc(n)$ while the gain is gain $G(n-1)$, and
change the gain from gain $G(n)$ to $G(n-1)$ immediately after the power level P1 becomes smaller than the switching threshold $Pc(n)$ when the first power level changes from a value larger than the switching threshold $Pc(n)$ to a value smaller than the switching threshold $Pc(n)$ while the gain is gain $G(n)$.

9. The amplifier circuit according to claim 1, wherein the controller is operable to stop power supplied to the first detector while which the first power level is not sent to the controller.

10. The amplifier circuit according to claim 1, wherein the target quality level is determined based on a Doppler frequency.

11. The amplifier circuit according to claim 1, further comprising
a radio-frequency (RF) variable gain amplifier connected between the output port of the variable gain amplifier and the mixer, wherein
the controller is operable to change the gain of the variable gain amplifier and a gain of the RF variable gain amplifier simultaneously.

12. The amplifier circuit according to claim 1, further comprising
an intermediate-frequency (IF) variable gain amplifier connected between the filter and the first detector, wherein
the controller is operable to change the gain of the variable gain amplifier and a gain of the IF variable gain amplifier simultaneously.

13. The amplifier circuit according to claim 1, wherein
the signal input to the input port has a guard interval, and
the controller changes the gain of the variable gain amplifier within a period of the guard interval.

14. The amplifier circuit according to claim 1, wherein
the controller is operable to change the gain of the variable gain amplifier based on a value obtained by averaging the first power level for a predetermined period.

15. A receiver comprising;
the amplifier circuit according to claim 1;
a signal processor that processes a signal output from the filter of the amplifier circuit; and
a display that displays an image based on the processed signal.

# FIG. 1

Local Oscillator — 7A

Signal Processor — 15

Display — 16

Si

2 — 4 — 3 — S1 — 6 — S2

SL

7 — S3 — Filter — 8 — S4 — 9 — S5 — A/D Converter — 10

Detector — 12

Detector — 11

Controller — 5

P2

P1

SF

4A — 13

1

14

EP 2 251 985 A1

# FIG. 2

Power

BW    BW    BW

Adjacent      Received      Adjacent      Frequency
Channel       Channel       Channel
(Interfering Wave) (Desired Wave) (Interfering Wave)

# FIG. 3A

C/N Ratio (Quality Level)

Target C/N Ratio Q1
(Target Quality Level)

Pc  Pss    Power Level P1

# FIG. 3B

Target C/N Ratio (Target Quality Level)

Q11

Q12

f d2                                    f d1
→ Doppler Frequency fd

# FIG. 3C

Target C/N Ratio (Target Quality Level)

Q11
Q13

A f d                    B f d

f d3                    f dc            f d1
→ Doppler Frequency fd

# FIG. 4

C/N Ratio
(Quality Level)

Target C/N ratio
(Target Quality Level)

Pc1  Pss

Pc2

Power Level P1

# FIG. 5

C/N Ratio
(Quality Level)

30

31

Target C/N ratio
(Target Quality Level)

Pc3  Pc4  Pss

Power Level P1

# FIG. 6A

# FIG. 6B

| Frequency (MHz) / Ratio RS | Switching Criteria Value (dBm) | | | | |
|---|---|---|---|---|---|
| | Value 1 | Value 2 | · · · | Value n-1 | Value n |
| 473 | -80.1 | -82.3 | · · · | -84.9 | -82.9 |
| 475 | -80.5 | -82.1 | · · · | -83 | -82.3 |
| · · · | · · · | · · · | · · · | · · · | · · · |
| 761 | -79.2 | -81.5 | · · · | -83.6 | -83.1 |
| 767 | -79.6 | -81.7 | · · · | -82.1 | -83.7 |

EP 2 251 985 A1

# FIG. 7

## FIG. 8

## FIG. 9

# FIG. 10

EP 2 251 985 A1

# FIG. 11

# FIG. 12

Output Power Level Pout1(dBm)

Ps    Input Power Level Pin1(dBm)

# FIG. 13

Output Power Level Pout2(dBm)

Ps    Input Power Level Pin1(dBm)

## INTERNATIONAL SEARCH REPORT

| International application No. |
| --- |
| PCT/JP2009/000789 |

A.  CLASSIFICATION OF SUBJECT MATTER
*H04B1/16*(2006.01)i, *H03G3/20*(2006.01)i, *H03G3/30*(2006.01)i, *H04B1/18*
(2006.01)i

According to International Patent Classification (IPC) or to both national classification and IPC

B.  FIELDS SEARCHED

Minimum documentation searched (classification system followed by classification symbols)
H04B1/16, H03G3/20, H03G3/30, H04B1/18

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2004-297362 A  (Murata Mfg.  Co.,  Ltd.),<br>21 October, 2004 (21.10.04),<br>Full text; all drawings<br>(Family: none) | 1,6,9,11-15<br>5,10<br>2-4,7,8 |
| X<br><br>Y<br>A | US 2008/0051050 A1  (Integrant Technologies<br>Inc.),<br>28 February, 2008 (28.02.08),<br>Full text; Fig. 2<br>& JP 2008-54314 A          & US 2008/0051050 A1<br>& EP 1895657 A1           & KR 10-0726958 B1<br>& CN 101132183 A | 1-3,9,11-13,<br>15<br>5,10<br>4,6-8,14 |

☒  Further documents are listed in the continuation of Box C.        ☐   See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    13 April, 2009 (13.04.09) | Date of mailing of the international search report<br>    21 April, 2009 (21.04.09) |
| --- | --- |
| Name and mailing address of the ISA/<br>    Japanese Patent Office | Authorized officer |
| Facsimile No. | Telephone No. |

Form PCT/ISA/210 (second sheet) (April 2007)

## INTERNATIONAL SEARCH REPORT

| | International application No. |
|---|---|
| | PCT/JP2009/000789 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2006-25001 A  (Matsushita Electric Industrial Co., Ltd.),<br>26 January, 2006 (26.01.06),<br>Full text; all drawings<br>(Family: none) | 1,9,11-13,15<br>10<br>2-8,14 |
| Y | JP 2003-124759 A  (Matsushita Electric Industrial Co., Ltd.),<br>25 April, 2003 (25.04.03),<br>Full text; all drawings<br>(Family: none) | 10 |

Form PCT/ISA/210 (continuation of second sheet) (April 2007)

**REFERENCES CITED IN THE DESCRIPTION**

**Patent documents cited in the description**

- JP 2003133983 A